# EUROPÄISCHE PATENTANMELDUNG

(11) **EP 1 255 351 A1**
(43) Veröffentlichungstag der Anmeldung: **06.11.2002**
(21) Anmeldenummer: 01810422.4
(22) Anmeldetag: 30.04.2001
(51) Int. Cl.: H03G 1/00

(54) **Verstärkerschaltung**

(71) Anmelder: Ascom Systec AG, 5506 Mägenwil (CH)
(72) Erfinder: Ellinger Frank, D-88048 Friedrichshafen (DE)
(74) Vertreter: Roshardt, Werner Alfred, Dipl.-Phys.

(57) **Zusammenfassung**

Bei einer Verstärkerschaltung (1) für einen steuerbaren Verstärker (variable gain amplifier, VGA) sind zwei Transistoren (7.1, 7.2) vorgesehen. Das zu verstärkende Eingangssignal wird zur Gateelektrode (8.1) des ersten Transistors (7.1) geführt. Das Ausgangssignal wird von der Gateelektrode (8.2) des zweiten Transistors abgegriffen. Die Steuerung der Verstärkung erfolgt über eine am Steuereingang anliegende Steuerspannung, welche über einen Spannungsteiler auf die Drainelektrode (9.1) des ersten Transistors (7.1) bzw. auf die Gateelektrode (8.2) des zweiten Transistors (7.2) geführt wird, wobei die Drainelektrode des ersten Transistors (7.1) über eine geeignete Impedanz mit der Gateelektrode des zweiten Transistors (7.2) verbunden ist. Beide Transistoren (7.1, 7.2) werden mit je einer konstanten Spannung (11.1, 11.2) gespiesen, wobei der erste Transistor (7.1) über die Gateelektrode (8.1) und der zweite Transistor (7.2) über die Drainelektrode (9.2) gespiesen wird.

## Beschreibung

Die Erfindung betrifft eine Verstärkerschaltung mit einem Signaleingang, einem Signalausgang und einem Steuereingang sowie einem ersten und einem zweiten Transistor mit je einer Steuerelektrode sowie je einer ersten und einer zweiten Leitungselektrode. Ferner betrifft die Erfindung ein Verfahren zur Bildung eines Ausgangssignals sowie eine Vorrichtung zum Senden und/oder Empfangen von Signalen mit einer derartigen Verstärkerschaltung.

### Stand der Technik

In vielen Telekommunikations-Anwendungen werden heute Verstärker mit variabler, d. h. steuerbarer Verstärkung, sogenannten VGA's (variable gain amplifier), eingesetzt. So wird beispielsweise die Verstärkung in den einzelnen Sende- bzw. Empfangspfaden eines adaptiven Antennen-Systems mittels derartiger Verstärker realisiert.

Bei bekannten VGA's weist das Ausgangssignal gegenüber dem Eingangssignal jedoch nicht nur eine bestimmte Verstärkung auf, auch seine Phase wird gegenüber dem Eingangssignal mehr oder weniger stark gedreht. Da diese Phasendrehung jedoch nicht konstant ist, sondern stark von der jeweiligen Verstärkung abhängt, ist dieser Effekt in der Regel unerwünscht und muss mit geeigneten Mitteln kompensiert werden. Typischerweise werden hierfür spezielle Schaltungen verwendet. Nebst zusätzlichem Entwicklungsaufwand und entsprechendem Zeitbedarf fallen auch der erhöhte Platzbedarf einer entsprechenden elektronischen Schaltung sowie vor allem deren Kalibrierung negativ ins Gewicht.

Aus dem Artikel "Performance of Dual-Gate GaAs MESFET's as Gain-Controlled Low-Noise Amplifiers and High-Speed Modulators" von Liechti et al. aus "Transactions on microwave theory and techniques" vom Juni 1975 ist bekannt, dass bei einem Dual-Gate Transistor bei manchen Anwendungen die Phasenvariation mittels einer geeigneten Terminierung verringert werden kann. Allerdings wird dadurch auch die maximale Verstärkung verringert.

In dem Artikel "An MMIC Variable-Gain Amplifier Using a Cascode-Connected FET with Constant Phase Deviation" von Hayashi et al. aus "IEICE Trans. Electron." vom Januar 1998 ist beschrieben, wie bei Dual-Gate Transistoren die verstärkungsabhängigen Phasenänderungen mittels eines geeigneten Bias zwischen den beiden Gateelektroden verringert werden kann. Auch diese Lösung gilt jedoch nur für Dual-Gate Transistoren und ist nicht allgemein gültig.

Zudem haben Dual-Gate Transistoren den Nachteil, dass sie grössere Versorgungsspannungen benötigen als Single-Gate Transistoren. Dies jedoch widerspricht den gängigen Trends zu kleineren, leichteren und kompakteren Geräten für die Mobilkommunikation. Darüberhinaus sind Single-Gate Transistoren auch preisgünstiger als Dual-Gate Transistoren.

### Darstellung der Erfindung

Aufgabe der Erfindung ist es, eine Verstärkerschaltung der eingangs genannten Art anzugeben, welche die Nachteile beim Stand der Technik vermeidet und welche es insbesondere ermöglicht, kostengünstige und kompakte VGA's zu konstruieren, bei welchen das Ausgangssignal gegenüber dem Eingangssignal bei variabler Verstärkung nur einer minimalen Änderung der Phasendrehung unterliegt.

Die Lösung der Aufgabe ist durch die Merkmale des Anspruchs 1 definiert. Gemäss der Erfindung umfasst die Verstärkerschaltung einen Signaleingang, einen Steuereingang, einen Signalausgang sowie zwei Transistoren, welche die Verstärkung realisieren. D. h. ein am Signaleingang anliegendes Eingangssignal wird in ein am Signalausgang abgreifbares Ausgangssignal verstärkt, wobei die Verstärkung mit dem am Steuereingang anliegenden Steuersignal gesteuert werden kann. Hierbei drehen beide Transistoren das Eingangssignal um eine bestimmte, von der jeweils eingestellten Verstärkung und damit vom Steuersignal abhängige Phase. Es können sowohl bipolare Transistoren, als auch Feldeffekttransistoren verwendet werden. Um eine einheitliche Terminologie für beide Arten von Transistoren zu verwenden, werden die Basis- bzw. die Gateelektrode im Folgenden als Steuerelektrode und die Kollektor- bzw. Drainelektrode respektive die Emitter- bzw. Sourceelektrode als Leitungselektroden bezeichnet.

Erfindungsgemäss werden die Transistoren nun derart zusammengeschaltet, dass die Phasendrehung des Ausgangssignals gegenüber dem Eingangssignal weitgehend unveränderlich ist. D. h. die Änderungen der Phasendrehungen der einzelnen Transistoren heben sich im gewünschten Verstärkungsbereich gegenseitig praktisch auf, sodass deren Summe weitgehend konstant ist.

Mit einem einzigen, am Steuereingang anliegenden Steuersignal, kann auf diese Art und Weise die Verstärkung beider Transistoren gleichzeitig gesteuert werden, wobei die beiden Anteile des Steuersignals für die beiden Transistoren beispielsweise mit einem Spannungsteiler eingestellt werden können. Unabhängig von der Art der Transistoren können somit VGA's entwickelt werden, bei welchen das Ausgangssignal gegenüber dem Eingangssignal zwar phasenverschoben ist, bei welchen diese Phasenverschiebung aber unabhängig von der eingestellten Verstärkung praktisch konstant ist.

Damit erübrigen sich aufwendige Schaltungen zur Phasenkompensation und es kann nicht nur bei der Planung und Herstellung von Verstärkerschaltungen viel Zeit, und damit auch Kosten eingespart werden, auch die aufwendige Kalibrierung und Nachführung dieser Schaltungen entfällt.

Ein weiterer Vorteil ist, dass an die zur Realisierung einer erfindungsgemässen Verstärkerschaltung zu verwendenden Transistoren keine speziellen Anforderungen hinsichtlich der Phasendrehung gestellt werden, womit auch kostengünstige Transistoren verwendet werden können.

Die Ansteuerung der beiden zusammengeschalteten Transistoren kann grundsätzlich auf verschiedene Arten erfolgen. So kann beispielsweise nur einer der Transistoren direkt angesteuert werden, wobei die Ansteuerung über die Steuerelektrode oder über eine der Leitungselektroden erfolgen kann.

Vorzugsweise werden bei der Erfindung jedoch beide Transistoren angesteuert und zwar derart, dass einer der Transistoren über die Gateelektrode und der andere Transistor über eine der Leitungselektroden angesteuert wird. Werden beispielsweise Feldeffekttransistoren (FET) verwendet, wird beispielsweise einer der beiden gate- und der andere draingesteuert. D. h. der Steuereingang der Verstärkerschaltung ist über eine erste Steuerimpedanz mit einer ersten Leitungselektrode des ersten Transistors sowie über eine zweite Steuerimpedanz mit der Steuerelektrode des zweiten Transistors verbunden. Unter dem Begriff Impedanz werden hierbei neben einzelnen Bauelementen auch beliebige Kombinationen mehrerer Bauelemente verstanden, wobei auch ein Kurzschluss bzw. ein Unterbruch als Impedanz angesehen wird. Die Steuerimpedanzen sind beispielsweise als ohmsche Widerstände ausgebildet.

Auch für die Speisung der Verstärkerschaltung gibt es grundsätzlich verschiedene Möglichkeiten. So kann im Prinzip jede der drei Elektroden zur Speisung des Transistors verwendet werden.

Zur Lösung der oben genannten Aufgabe hat es sich jedoch als vorteilhaft erwiesen, zur Speisung der Verstärkerschaltung die Steuerelektrode des ersten Transistors über eine erste Speisungsimpedanz mit einem ersten Speisungsanschluss und die erste Leitungselektrode des zweiten Transistors über eine zweite Speisungsimpedanz mit einem zweiten Speisungsanschluss zu verbinden.

Entsprechend ist die zweite Leitungselektrode des ersten Transistors über eine erste Abschlussimpedanz, die Steuerelektrode des zweiten Transistors über eine zweite Abschlussimpedanz und die zweite Leitungselektrode des zweiten Transistors über eine dritte Abschlussimpedanz mit einem auf Massepotential liegenden Masseanschluss verbunden.

Die geeignete Wahl der Impedanzen der einzelnen Verbindungsleitungen ist auf vielfältige Art und Weise möglich, denn es gibt für jede einzelne Verbindung neben einem Kurzschluss, oder einem Unterbruch, einem ohmschen Widerstand, einer Kapazität oder einer Induktivität grundsätzlich fast unendlich viele Kombinationen von Parallel- und/oder Serieschaltungen dieser Bauelemente. Die Art der Impedanz und die Werte der einzelnen Bauelemente werden beispielsweise entsprechend den notwendigen Anpassungen der Schaltung hinsichtlich Verstärkung, Abschluss und Frequenz gewählt.

Für die Speisungs- und Abschlussimpedanzen werden folgende Varianten bevorzugt: Als erste Speisungsimpedanz sowie als zweite Abschlussimpedanz wird je ein ohmscher Widerstand, als zweite Speisungsimpedanz eine Induktivität, als erste Abschlussimpedanz eine Parallelschaltung eines ohmschen Widerstandes und einer Kapazität und als dritte Abschlussimpedanz ein Kurzschluss verwendet.

Bei einer Frequenz des Eingangssignals von ca. 5 GHz (Gigahertz), einem Schaltungsabschluss von 50 Ω (Ohm) und einem Verstärkungsbereich von etwa 20 dB (dezibel) weisen die Kapazitäten Werte in der Grössenordnung von einigen pF (Picofarad), die Induktivitäten Werte in der Grössenordnung von einigen nH (Nanohenry) und die Widerstände Werte in der Grössenordnung von einigen Dutzend bis einigen Hundert Ω auf.

Um das Verhalten der Verstärkerschaltung weiter zu verbessern, können weitere Massnahmen ergriffen werden. So werden zwischen dem Masseanschluss und den Einspeisungspunkten der Steuer- bzw. der Speisespannungen vorzugsweise zusätzliche Kapazitäten eingefügt. D. h. je eine Kapazität zweigt zwischen dem ersten Speisungsanschluss und der ersten Speisungsimpedanz, zwischen dem zweiten Speisungsanschluss und der zweiten Speisungsimpedanz, zwischen dem Steuereingang und der ersten Steuerimpedanz sowie zwischen dem Steuereingang und der zweiten Steuerimpedanz ab und wird auf Masse geführt.

Bei einer bevorzugten Ausführungsform der Erfindung sind die beiden Transistoren folgendermassen zusammengeschaltet: Der Signaleingang wird über eine Eingangsimpedanz mit der Steuerelektrode des ersten Transistors, die erste Leitungselektrode des zweiten Transistors über eine Ausgangsimpedanz mit dem Signalausgang und die erste Leitungselektrode des ersten Transistors über eine Verbindungsimpedanz mit der Steuerelektrode des zweiten Transistors verbunden. D. h. für eine Realisierung mit FET's: der draingesteuerte Transistor liegt in Arbeitsrichtung des Verstärkers vor dem gategesteuerten Transistor.

Die Eingangsimpedanz, die Ausgangsimpedanz und die Verbindungsimpedanz sind beispielsweise je als Serieschaltung einer Kapazität und einer Induktivität ausgebildet.

Bei einer anderen bevorzugten Ausführungsform der Erfindung ist der Signaleingang über eine Eingangsimpedanz mit der Steuerelektrode des zweiten Transistors, die erste Leitungselektrode des ersten Transistors über eine Ausgangsimpedanz mit dem Signalausgang und die erste Leitungselektrode des zweiten Transistors über eine Verbindungsimpedanz mit der Steuerelektrode des ersten Transistors verbunden. Beim Beispiel mit FET's heisst dies, dass der gategesteuerte vor dem draingesteuerten Transistor liegt.

Die Eingangsimpedanz, die Ausgangsimpedanz und die Verbindungsimpedanz sind beispielsweise auch bei dieser Ausführungsform als Serieschaltung einer Kapazität und einer Induktivität ausgebildet.

Die Realisierung der Verstärkerschaltung kann auf verschiedene Arten erfolgen. Die Verstärkerschaltung kann beispielsweise sehr einfach aus diskreten Bauteilen aufgebaut werden.

Die beschriebene Verstärkerschaltung eignet sich jedoch sehr gut zur Realisierung als integrierte Schaltung und wird daher auch bevorzugt als solche ausgeführt.

Zur Implementation eignen sich sämtliche Arten von Transistoren wie bipolare Transistoren oder auch Feldeffekttransistoren. Aber nicht nur die Art der verwendeten Transistoren ist nebensächlich, auch die Art der Herstellung der Transistoren, d. h. welche Methoden und Verfahren verwendet wurden, um den Transistor herzustellen, ist unerheblich.

Allerdings werden bei einer bevorzugten Ausführungsform der Erfindung Metall Halbleiter Feldeffekttransistoren (MESFET, metall semiconductor field effect transistor) auf Gallium-Arsenid Basis verwendet. Diese sind zum Einen nämlich weit verbreitet und zum Andern eignen sie sich bestens zur Bildung von integrierten Schaltkreisen, wie sie für die moderne Telekommunikation häufig verwendet werden. Bei diesen Feldeffekttransistoren entspricht die Gateelektrode beispielsweise der Steuerelektrode, die Drainelektrode der ersten Leitungselektrode und die Sourceelektrode der zweiten Leitungselektrode.

Bei dem erfindungsgemässen Verfahren zur Bildung eines Ausgangssignals wird ein gegebenes Eingangssignal dem Signaleingang der vorgängig beschriebenen Verstärkerschaltung zugeführt. Am Steuereingang wird ein Steuersignal angelegt und am Signalausgang kann dann das entsprechend verstärkte Ausganssignal abgegriffen werden, wobei das Ausgangssignal gegenüber dem Eingangssignal nur minimal phasengedreht ist.

Eine erfindungsgemässe Vorrichtung zum Senden und/oder Empfangen von Signalen zeichnet sich nun dadurch aus, dass sie wenigstens eine erfindungsgemässe Verstärkerschaltung aufweist. Zudem kann ein von der Vorrichtung empfangenes Signal der Verstärkerschaltung zugeführt und entsprechend einem angelegten Steuersignal verstärkt werden und/oder das Ausgangssignal am Signalausgang der Verstärkerschaltung abgegriffen und gesendet werden. Das Senden bzw. Empfangen umfasst hierbei sämtliche Arten von Datenübertragungen über die verschiedensten Übertragungsmedien: elektrische, optische, akustische oder andere Datenübertragungen über elektrische oder optische Leitungen aber auch andere Übertragungsmedien wie Gase oder Flüssigkeiten. Zur Verarbeitung mit der erfindungsgemässen Verstärkerschaltung muss das empfangene Signal lediglich mit einem geeigneten Wandler in ein elektrisches Signal umgeformt werden. Entsprechendes gilt natürlich beim Senden des Ausgangssignals.

Aus der nachfolgenden Detailbeschreibung und der Gesamtheit der Patentansprüche ergeben sich weitere vorteilhafte Ausführungsformen und Merkmalskombinationen der Erfindung.

### Kurze Beschreibung der Zeichnungen

Die zur Erläuterung des Ausführungsbeispiels verwendeten Zeichnungen zeigen:
- Fig. 1: Eine schematische Darstellung einer erfindungsgemässen Schaltungsanordnung;
- Fig. 2: ein Diagramm mit dem Phasen- und Amplitudenverlauf in Abhängigkeit des Steuersignals,

- Fig. 3: eine mögliche Anwendung der Erfindung und
- Fig. 4: eine schematische Darstellung einer weiteren erfindungsgemässen Schaltungsanordnung.
Grundsätzlich sind in den Figuren gleiche Teile mit gleichen Bezugszeichen versehen.

### Wege zur Ausführung der Erfindung

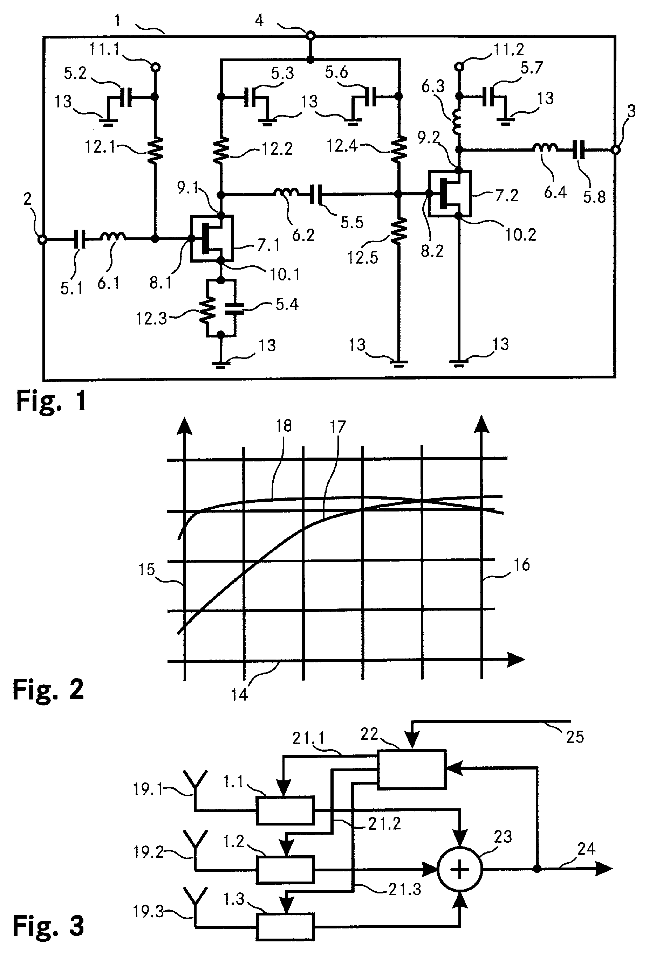

Figur 1 zeigt eine schematische Darstellung einer erfindungsgemässen Verstärkerschaltung 1. Sie umfasst einen Signaleingang 2, einen Signalausgang 3 und einen Steuereingang 4. Das zu verstärkende Signal wird an den Signaleingang 2 gelegt und über eine Serieschaltung einer Kapazität 5.1 und einer Induktivität 6.1 zur Steuerelektrode eines Transistors 7.1 geführt. In diesem Beispiel werden FET's verwendet. D. h. das zu verstärkende Signal wird zur Gateelektrode 8.1 des Transistors 7.1 geführt. Dieser wird gespiesen durch eine konstante Spannung, welche an einem Speisungsanschluss 11.1 anliegt und über einen ohmschen Widerstand 12.1 ebenfalls mit dem Gate 8.1 verbunden ist. Zwischen dem Speisungsanschluss 11.1 und der Masse 13 ist zudem eine weitere Kapazität 5.2 vorgesehen.

Die Verstärkung des Transistors 7.1 wird gesteuert durch eine am Steuereingang 4 anliegende Steuerspannung, welche über einen Widerstand 12.2 mit der Drainelektrode 9.1 des Transistors 7.1 verbunden ist. Auch hier ist zwischen dem Steuereingang 4 und der Masse 13 eine Kapazität 5.3 zwischengeschaltet. Die Sourceelektrode 10.1 ist über eine Parallelschaltung eines Widerstandes 12.3 und einer Kapazität 5.4 auf Masse 13 geführt.

Die Drainelektrode 9.1 des Transistors 7.1 ist über eine Serieschaltung einer Iduktivität 6.2 und einer Kapazität 5.5 mit der Gateelektrode 8.2 des Transistors 7.2 verbunden. Die Verstärkung des Transistors 7.2 wird ebenfalls über die am Steuereingang 4 anliegende Steuerspannung gesteuert, welche wiederum über einen Widerstand 12.4 jedoch nicht auf die Drainelektrode 9.2, sondern auf die Gateelektrode 8.2 geführt wird. Auch hier liegt zwischen dem Steuereingang 4 und der Masse 13 eine Kapazität 5.6. Zudem ist die Gateelektrode 8.2 über einen weiteren Widerstand 12.5 ebenfalls mit Masse 13 verbunden. Die Sourceelektrode 10.2 ist direkt auf Masse 13 geführt.

Die Speisung des Transistors 7.2 erfolgt über eine konstante Spannung, welche am Speisungsanschluss11.2 anliegt und über eine Induktivität 6.3 auf die Dreinelektrode 8.2 geführt ist. Zwischen dem Speisungsanschluss 11.2 und der Masse 13 ist auch hier eine Kapazität 5.7 vorgesehen.

Die Drainelektrode 9.2 ist über eine Serieschaltung einer Induktivität 6.4 und einer Kapazität 5.8 mit dem Signalausgang 3 verbunden, wo das verstärkte Eingangssignal als Ausgangssignal der Verstärkerschaltung 1 abgegriffen werden kann.

Als Beispiel für eine konkrete Realisierung dieser Verstärkerschaltung für eine Frequenz des Eingangssignals in der Grössenordnung von 5.2 GHz können MESFET's (metal semiconductor FET) und Bauelemente mit den folgenden Werten verwendet werden: Ausser der Kapazität 5.5, welche einen Wert von 2.5 pF aufweist, haben alle Kapazitäten 5.1, 5.2, 5.3, 5.4, 5.6, 5.7, 5.8 einen Wert von 5 pF. Die Werte der Induktivitäten sind: Induktivität 6.1 hat einen Wert von 2 nH, Induktivität 6.2 hat einen Wert von 5 nH, Induktivität 6.3 hat einen Wert von 10 nH und Induktivität 6.4 hat einen Wert von 3 nH. Die Widerstände sind folgendermassen bemessen: Widerstand 12.1 mit 500 Ω, Widerstand 12.2 mit 1 kΩ, Widerstand 12.3 mit 150 Ω, Widerstand 12.4 mit 600 Ω und Widerstand 12.5 mit 300 Ω.

Die Gate-Weite der Transistoren 7.1 und 7.2 ist beispielsweise 150 µm und die Gate-Länge 0.6 µm. Die Schwellenspannung beträgt 0.14 V, die Transitfrequenz ist 18 GHz und der Ein- bzw. Ausgang ist jeweils auf 50 Ω abgestimmt. Zur Speisung der Transistoren 7.1 und 7.2 wird eine Spannung von 0.39 V an den Speisungsanschluss 11.1 und eine Spannung von 1.5 V an den Speisungsanschluss 11.2 gelegt.

Die am Steuereingang 4 anliegende Steuerspannung wird über einen Spannungsteiler auf die beiden Transistoren 7.1, 7.2 aufgeteilt, wobei das am Eingang anliegende Eingangssignal entsprechend der Steuerspannung verstärkt wird.

In dem Diagramm gemäss Figur 2 ist auf der Abszissenachse die Steuerspannung 14 von etwa 0.5 V bis ca. 1.75 V in Schritten von 0.25 V aufgetragen. In Ordinatenrichtung ist einerseits die Phasendrehung 15 und andererseits die Verstärkung 16 des Ausgangssignals gegenüber dem Eingangssignal aufgetragen. Die Phasendrehung 15 ist von 50° bis 90° in Schritte von 10° und die Verstärkung 16 von -20 dB bis +20 dB in Schritte von 10 dB unterteilt.

Für die genannte Frequenz von etwa 5.2 GHz ist der Verstärkungsverlauf 17 in dB eingetragen. Die Verstärkung kann für den Steuerspannungsbereich von 0.6 V bis 1.75 V von knapp -10 dB bis gut +10 dB, d. h. in einem Kontrollbereich von etwa 20 dB ausgesteuert werden.

Die jeweils zugehörige Phasendrehung ist als Phasenverlauf 18 eingetragen, wobei die Phasendrehung für den genannten Steuerspannungsbereich von 0.6 V bis 1.75 V zwischen knapp 80° und gut 85°, d. h. um etwa ±3° variiert.

Die Phasendrehung ist damit über den gesamten Verstärkungsbereich von etwa 20 dB mehrheitlich unveränderlich und kann in vielen Anwendungen vernachlässigt werden.

Figur 3 zeigt beispielhaft eine Anwendung der Erfindung in einem adaptiven Antennensystem mit drei Empfangspfaden. Jeder Empfangspfad weist beispielsweise eine Antenne 19.1, 19.2, 19.3 auf. Das von der jeweiligen Antenne 19.1, 19.2, 19.3 empfangene Signal wird einer erfindungsgemässen Verstärkerschaltung 1.1, 1.2, 1.3 zugeführt. Diese verstärken jeweils die zugeführten Empfangssignale entsprechend den jeweiligen Steuersignalen 21.1, 21.2, 21.3, die von einem Komparator 22 bereitgestellt werden. Die entsprechend verstärkten Ausgangssignale 20.1, 20.2, 20.3 werden einem Addierer 23 zugeführt, der diese zu einem Gesamtsignal 24 addiert und zur Weiterverarbeitung zur Verfügung stellt.

Eine verstärkungsabhängige Phasenkorrektur der 20.1, 20.2, 20.3 Ausgangssignale der Verstärkerschaltungen 1.1, 1.2, 1.3, wie sie entsprechende Antennensysteme typischerweise aufweisen, ist nicht notwendig, da die Änderung der Phasendrehung der empfangenen Signale in Abhängigkeit der Verstärkung nur minimal ist.

Die Bereitstellung der Steuersignale 21.1, 21.2, 21.3 erfolgt durch den Komparator 22. Zu diesem Zweck vergleicht dieser beispielsweise das Gesamtsignal 24 mit einem entsprechenden bekannten Signal 25, berechnet aufgrund der Unterschiede die Gewichtung für die einzelnen Empfangspfade und generiert dementsprechend die Steuersignale 21.1, 21.2, 21.3 für die Verstärkerschaltung jedes einzelnen Empfangspfades.

Um diesen Vergleich durchführen zu können, müssen die empfangenen Signale mit dem bekannten Signal 25 übereinstimmen, weshalb hierfür beispielsweise eine Synchronisationssequenz oder ein anderes, vordefiniertes Signal verwendet wird. Dieses vordefinierte Signal bezieht der Komparator 22 beispielsweise aus einem lokalen Speicher oder es wird ihm von aussen zugeführt.

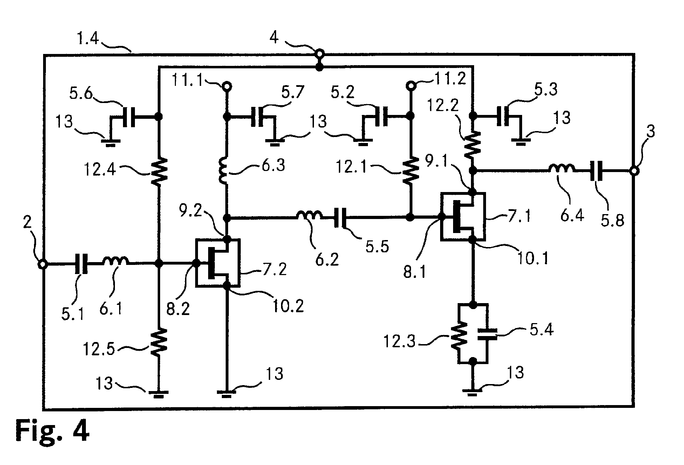

Figur 4 zeigt eine schematische Darstellung einer weiteren erfindungsgemässen Verstärkerschaltung 1.4. Sie ist der Verstärkerschaltung 1 aus Fig. 1 sehr ähnlich. Der Unterschied besteht darin, dass die beiden Transistoren 7.1 und 7.2 jeweils inklusive der zugehörigen Impedanzen auf Masse 13 bzw. auf die Speisungsanschlüsse 11.1, 11.2 vertauscht wurden. Bei Fig. 1 liegt der draingesteuerte Transistor 7.1 in Arbeitsrichtung der Verstärkerschaltung 1 vor dem gategesteuerten Transistor 7.2, wohingegen bei der Verstärkerschaltung 1.4 aus Fig. 4 der gategesteuerten Transistor 7.2 vor dem draingesteuerten Transistor 7.1 liegt. Die Werte der einzelnen Bauelemente entsprechen denjenigen aus Fig. 1.

Zusammenfassend ist festzustellen, dass es die Erfindung erlaubt, eine Verstärkerschaltung für eine variable, steuerbare Verstärkung anzugeben, bei welcher die Änderung der Phasendrehung in Abhängigkeit der Verstärkung nur minimal ist. Dies ermöglicht die Herstellung einfacher integrierter Verstärkerschaltungen, welche weniger Platzbedarf und weniger Energieverbrauch aufweisen und damit kostengünstiger sind als bekannte Verstärkerschaltungen.

## Patentansprüche

1. Verstärkerschaltung zur steuerbaren Verstärkung eines an einem Signaleingang anliegenden Eingangssignals in ein an einem Signalausgang abgreifbares Ausgangssignal, wobei die Verstärkung mit einem an einem Steuereingang anliegenden Steuersignal steuerbar ist, **dadurch gekennzeichnet, dass** die Verstärkerschaltung zwei Transistoren aufweist, wobei die Transistoren derart zusammengeschaltet und über den Steuereingang ansteuerbar sind, dass das Ausgangssignal gegenüber dem Eingangssignal eine weitgehend unveränderliche Phasendrehung als Summe einer Phasendrehung des ersten Transistors und einer Phasendrehung des zweiten Transistors aufweist.

2. Verstärkerschaltung nach Anspruch 1, **dadurch gekennzeichnet, dass** beide Transistoren je eine Steuerelektrode sowie je zwei Leitungselektroden aufweisen und der Steuereingang über eine erste Steuerimpedanz mit einer ersten Leitungselektrode des ersten Transistors sowie über eine zweite Steuerimpedanz mit der Steuerelektrode des zweiten Transistors verbunden ist, wobei die Steuerimpedanzen insbesondere als ohmsche Widerstände ausgebildet sind.

3. Verstärkerschaltung nach Anspruch 2, **dadurch gekennzeichnet, dass** die Steuerelektrode des ersten Transistors über eine erste Speisungsimpedanz mit einem ersten Speisungsanschluss, eine erste Leitungselektrode des zweiten Transistors über eine zweite Speisungsimpedanz mit einem zweiten Speisungsanschluss, die zweite Leitungselektrode des ersten Transistors über eine erste Abschlussimpedanz mit einem Masseanschluss, die Steuerelektrode des zweiten Transistors über eine zweite Abschlussimpedanz mit dem Masseanschluss und die zweite Leitungselektrode des zweiten Transistors über eine dritte Abschlussimpedanz mit dem Masseanschluss verbunden ist.

4. Verstärkerschaltung nach Anspruch 3, **dadurch gekennzeichnet, dass** die erste Speisungsimpedanz und die zweite Abschlussimpedanz je ein ohmscher Widerstand, die zweite Speisungsimpedanz eine Induktivität, die erste Abschlussimpedanz eine Parallelschaltung eines ohmschen Widerstandes und einer Kapazität und die dritte Abschlussimpedanz ein Kurzschluss ist.

5. Verstärkerschaltung nach Anspruch 4, **dadurch gekennzeichnet, dass** zwischen dem ersten Speisungsanschluss und der ersten Speisungsimpedanz, zwischen dem zweiten Speisungsanschluss und der zweiten Speisungsimpedanz, zwischen dem Steuereingang und der ersten Steuerimpedanz sowie zwischen dem Steuereingang und der zweiten Steuerimpedanz je eine Kapazität abzweigt und auf den Masseanschluss geführt ist.

6. Verstärkerschaltung nach einem der Ansprüche 1 bis 5, **dadurch gekennzeichnet, dass** der Signaleingang über eine Eingangsimpedanz mit der Steuerelektrode des ersten Transistors, eine erste Leitungselektrode des zweiten Transistors über eine Ausgangsimpedanz mit dem Signalausgang und eine erste Leitungselektrode des ersten Transistors über eine Verbindungsimpedanz mit der Steuerelektrode des zweiten Transistors verbunden ist, wobei die Eingangsimpedanz, die Ausgangsimpedanz und die Verbindungsimpedanz je insbesondere als Serieschaltung einer Kapazität und einer Induktivität ausgebildet ist.

7. Verstärkerschaltung nach einem der Ansprüche 1 bis 5, **dadurch gekennzeichnet, dass** der Signaleingang über eine Eingangsimpedanz mit der Steuerelektrode des zweiten Transistors, eine erste Leitungselektrode des ersten Transistors über eine Ausgangsimpedanz mit dem Signalausgang und eine erste Leitungselektrode des zweiten Transistors über eine Verbindungsimpedanz mit der Steuerelektrode des ersten Transistors verbunden ist, wobei die Eingangsimpedanz, die Ausgangsimpedanz und die Verbindungsimpedanz je insbesondere als Serieschaltung einer Kapazität und einer Induktivität ausgebildet ist.

8. Verstärkerschaltung nach einem der Ansprüche 1 bis 7, **dadurch gekennzeichnet, dass** sie als integrierte Schaltung ausgebildet ist.

9. Verstärkerschaltung nach einem der Ansprüche 1 bis 8, **dadurch gekennzeichnet, dass** die Transistoren ausgebildet sind als Feldeffekttransistoren mit je einer Gateelektrode, einer Drainelektrode und einer Sourceelektrode, insbesondere als Metall Halbleiter Feldeffekttransistoren auf Gallium-Arsenid Basis, wobei die Gateelektrode der Steuerelektrode, die Drainelektrode der ersten Leitungselektrode und die Sourceelektrode der zweiten Leitungselektrode entspricht.

10. Verfahren zur Bildung eines Ausgangssignals, wobei ein Eingangssignal einer Verstärkerschaltung zugeführt und das Ausgangssignal an der Verstärkerschaltung abgegriffen wird, **dadurch gekennzeichnet, dass** eine Verstärkerschaltung gemäss einem der Ansprüche 1 bis 9 verwendet wird, wobei das Eingangssignal dem Signaleingang der Verstärkerschaltung zugeführt, an den Steuereingang der Verstärkerschaltung ein Steuersignal angelegt und am Signalausgang das Ausgangssignal abgegriffen wird.

11. Vorrichtung zum Senden und/oder Empfangen von Signalen, **dadurch gekennzeichnet, dass** sie wenigstens eine Verstärkerschaltung gemäss einem der Ansprüche 1 bis 9 aufweist, wobei die Vorrichtung derart ausgebildet ist, dass ein empfangenes Signal dem Signaleingang der Verstärkerschaltung zugeführt und/oder ein am Signalausgang der Verstärkerschaltung abgegriffenes Signal gesendet werden kann.
